**Europäisches Patentamt**

**European Patent Office**

**Office européen des brevets**

(19)

(11) Veröffentlichungsnummer: **0 048 857**
**B1**

(12) **EUROPÄISCHE PATENTSCHRIFT**

(45) Veröffentlichungstag der Patentschrift:
16.01.85

(51) Int. Cl.⁴: **H 01 J 37/28**

(21) Anmeldenummer: 81107146.3

(22) Anmeldetag: 10.09.81

(54) Anordnung für stroboskopische Potentialmessungen mit einem Elektronenstrahl-Messgerät und Verfahren zum Betrieb einer solchen Anordnung.

(30) Priorität: 29.09.80 DE 3036660

(43) Veröffentlichungstag der Anmeldung:
07.04.82 Patentblatt 82/14

(45) Bekanntmachung des Hinweises auf die Patenterteilung:
16.01.85 Patentblatt 85/3

(84) Benannte Vertragsstaaten:
DE FR GB NL

(56) Entgegenhaltungen:
DE - B - 1 943 140
US - A - 3 628 012

THE REVIEW OF SCIENTIFIC INSTRUMENTS, Band 42, Nr. 2, Februar 1971 New York G.Y. ROBINSON "Stroboscopic Scanning Electron Microscopy at Gigahertz Frequencies" Seiten 251 bis 255
THE REVIEW OF SCIENTIFIC INSTRUMENTS, Band 49, Nr. 9, September 1978 New York T. HOSOKAWA et al. "Gigahertz Stroboscopy with the Scanning Electron Microscope" Seiten 1293 bis 1299
JOURNAL OF PHYSICS. E. SCIENTIFIC INSTRUMENTS, Band 11, 1978 London K.G. GOPINATHAN et al. "A Sampling Scanning Electron Microscope" Seiten 229 bis 233

(73) Patentinhaber: **Siemens Aktiengesellschaft, Berlin und München Wittelsbacherplatz 2, D-8000 München 2 (DE)**

(72) Erfinder: **Feuerbaum, Hans-Peter, Dipl.-Phys., Tucholskystrasse 22, D-8000 München 83 (DE)**

(56) Entgegenhaltungen: (Fortsetzung)
JOURNAL OF PHYSICS. E. SCIENTIFIC INSTRUMENTS, Band 11, 1978 London H.P. FEUERBAUM et al. "Beam Chopper for Subnanosecond Pulses in Scanning Electron Microscopy" Seiten 529 bis 532

## Beschreibung

Die Erfindung betrifft eine Anordnung für stroboskopische Potentialmessungen mit einem gepulsten Elektronenstrahl nach dem Oberbegriff des Anspruchs 1.

Hochfrequente Signalverläufe können mit einem Elektronenstrahl-Messgerät stroboskopisch gemessen werden. Als Prüfsonde dient dabei ein fein fokussierter Elektronenstrahl, der auf das Messobjekt, z.B. eine integrierte Schaltung, gerichtet wird. Durch die Wechselwirkung zwischen Elektronen und Festkörper werden u.a. Sekundärelektronen ausgelöst, die zur Abbildung eines Objekts herangezogen werden können. Diese Sekundärelektronen tragen auch Informationen über das elektrische Potential am Auftreffort. Unter Ausnützung des Stroboskopie-Effekts können auch mit hoher Nenn-Frequenz arbeitende Messobjekte quasistatisch im Potentialkontrast abgebildet werden. Zu diesem Zweck wird das zu untersuchende Messobjekt mit sich zyklisch wiederholenden Signalen angesteuert und in einem Rasterelektronenmikroskop abgebildet. Der Elektronenstrahl wird in jedem Zyklus nur einmal für kurze Zeit eingeschaltet, d.h. das Messobjekt wird nur während einer bestimmten Phase betrachtet. Die Abbildung ist somit eine Momentaufnahme der schnell arbeitenden Probe. Der Einschaltzeitpunkt des Elektronenstrahles kann innerhalb des Zyklus beliebig gewählt werden. Durch langsames Verschieben der Phase ist eine Zeitlupendarstellung der Schaltvorgänge möglich. Die Einschaltdauer des Elektronenstrahls kann bis zum Picosekundenbereich reduziert werden, d.h. die Zeitauflösung dieses Abbildungsverfahrens liegt im Picosekundenbereich. Die Elektronenpulse werden mit Hilfe eines Strahlaustastsystems erzeugt. Zweck der Erfindung ist die Erzeugung dieser Elektronenpulse und die Verarbeitung der Sekundärelektronenpuls-Signale.

Zur Erzeugung von kurzen Elektronenpulsen wurden bisher Ablenkstrukturen (Plattenkondensatoren, Wanderwellenanordnungen) verwendet, die den Elektronenstrahl aus dem Strahlengang auf eine Blende lenken. Für die Ansteuerung der Ablenkstrukturen gibt es prinzipiell zwei Möglichkeiten: Nach der Methode I (die von H. P. Feuerbaum und J. Otto in J. Phys. E: Sci. Instrum., Vol. 11, 1978, 529–532 angegebene Anordnung ist dafür verwendbar) wird eine Ablenkstruktur geerdet, während an der anderen Ablenkstruktur eine Gleichspannung angelegt wird. Ein der Gleichspannung überlagerter Austastimpuls legt diese Ablenkstruktur auf Erdpotential. Während des Austastimpulses ist der Raum zwischen den beiden Ablenkstrukturen feldfrei, so dass der Elektronenstrahl eingeschaltet ist. Die Elektronen-Pulsbreite wird bei diesem Verfahren durch die Breite des angelegten Austastimpulses bestimmt. Die kleinste bisher erreichte Elektronen-Pulsbreite beträgt 350 ps.

Nach der Methode II (K. G. Gopinathan, A. Gopinath, «A sampling scanning electron microscope», J. Phys. E: Sci. Instrum., Vol. 11, 1978, 229–233) werden kürzere Pulsbreiten ($\approx$ 10 ps) erreicht, wenn eine Ablenkstruktur geerdet wird, während an der anderen eine negative Gleichspannung $-U_o$ angelegt wird. Ein der Gleichspannung überlagerter Austastimpuls legt diese Ablenkstruktur etwa auf das Potential $+U_o$. Dabei wird der Elektronenstrahl während jeder Flanke eines Austastimpulses über eine Blende hinweg abgelenkt. Entsprechend der Antiegs- und Abfallflanke liefert diese Beschaltung zwei Elektronenpulse pro Austastimpuls.

Da eine stroboskopische Messung jedoch einen Elektronenpuls pro Signalzyklus, womit das Messobjekt angesteuert wird, erfordert, ist diese Beschaltung nur geeignet, wenn
a) einer der beiden Elektronenpulse durch ein zusätzliches Strahlaustastsystem aus dem Strahlengang gelenkt wird; das ist jedoch nur mit hohem mechanischen und elektronischen Aufwand möglich.
b) jeweils zwei aufeinanderfolgende Elektronenpulse den gleichen zeitlichen Abstand voneinander haben und die Frequenz des Signals, mit dem das Messobjekt zyklisch angesteuert wird, doppelt so gross ist wie die Frequenz des Austastimpulses. Bei diesem Verfahren kann jedoch eine hohe Zeitauflösung nur nach einer langwierigen Justierung des Abstands der beiden Elektronenpulse erreicht werden.

Der Erfindung liegt die Aufgabe zugrunde, eine Anordnung der eingangs genannten Art für stroboskopische Potentialmessungen anzugeben, die eine hohe Zeitauflösung ohne zusätzlichen Aufwand bezüglich der Signalverarbeitung oder bezüglich des Strahlaustastsystems ermöglicht.

Diese Aufgabe wird erfindungsgemäss durch eine Anordnung der eingangs genannten Art gelöst, die die kennzeichnenden Merkmale des Anspruchs 1 aufweist. Bei der Signalverarbeitung wird also ein zeitliches Fenster so gesetzt, dass pro Austastimpuls nur das Signal eines Elektronenpulses gemessen wird. Vorteilhafterweise wird für eine solche Signalverarbeitungseinrichtung ein modifizierter Boxcar-Integrator der Firma PAR verwendet.

Die erfindungsgemässe Anordnung kann vorteilhafterweise zwischen den obengenannten Betriebsarten nach der Methode I und nach der Methode II auf einfache Art umgeschaltet werden.

Ein Ausführungsbeispiel der Erfindung ist in der Zeichnung dargestellt und wird im folgenden näher erläutert.

Fig. 1 zeigt eine erfindungsgemässe Anordnung für stroboskopische Potentialmessungen mit einem Elektronenstrahl-Messgerät.

Fig. 2 zeigt die Beschaltung eines Strahlaustauschsystems nach der Methode I.

Fig. 3 zeigt die Beschaltung eines Strahlaustauschsystems nach der Methode II.

Fig. 4 zeigt das Prinzip der stroboskopischen Potentialmessung bei einer erfindungsgemässen Anordnung.

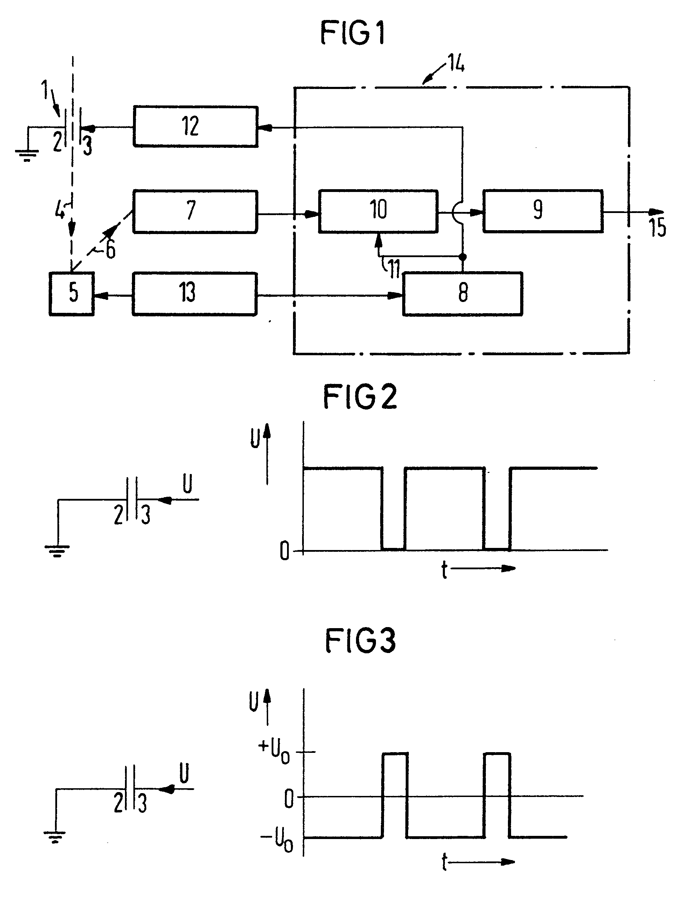

In Fig. 1 ist eine erfindungsgemässe Anordnung für stroboskopische Potentialmessungen mit einem Elektronenstrahl-Messgerät dargestellt. Als Grundlage für eine erfindungsgemässe Anordnung kann ein Elektronenstrahl-Messgerät nach dem angegebenen Stand der Technik verwendet werden, welches dann erfindungsgemäss zu modifizieren ist. Die Grundeinheit bildet ein modifiziertes Rasterelektronenmikroskop mit einem schnellen Strahlaustastsystem 1. Dieses Strahlaustastsystem 1 besitzt die beiden Ablenkstrukturen 2, 3. Um hochfrequente periodische Vorgänge im Messobjekt 5 stroboskopisch zu messen, wird ein Elektronenstrahl 4 von Primärelektronen synchron mit dem Vorgang gepulst so dass er das Messobjekt 5 nur in einer bestimmten Phase des hochfrequenten periodischen Vorganges trifft. Das Potential in dieser Phase des hochfrequenten periodischen Vorgangs wird mit Hilfe eines Spektrometers aus der Energie der pulsförmig ausgelösten Sekundärelektronen 6 bestimmt. Dazu wird das Signal der Sekundärelektronen 6, die das Spektrometer durchlaufen haben, in einer Scintillator-Fotomultiplier-Kombination 7 verstärkt.

Ein modifizierter Boxcar-Integrator 14 übernimmt dabei die Steuerung der Phase und die Signalverarbeitung. Ein Boxcar-Integrator ist ein Verstärker, der hochfrequente Signale mit einem Zeitfenster (Gate) nach dem Sampling-Prinzip abtastet. Der Boxcar-Integrator 14 weist eine Phasensteuerungseinheit 8, eine Signalverarbeitungseinheit 9 und eine Torschaltung 10 auf. Das Signal der Sekundärelektronen 6 gelangt nach der Verstärkung in der Scintillator-Fotomultiplier-Kombination 7 an den Eingang der Torschaltung 10. Die bei einer bestimmten Phase des hochfrequenten periodischen Vorgangs im Messobjekt 5 gemessenen Werte werden in der Signalverarbeitungseinheit 9 integriert und anschliessend verstärkt. Zur Anwendung in der Elektronenstrahlmesstechnik muss am Boxcar-Integrator 14 folgende Änderung durchgeführt werden: Zwischen der Phasensteuerungseinheit 8 und der Torschaltung 10 wird eine Verzögerungsschaltung 11 (ca. 150 ns) eingebaut. Ohne Verzögerung steuert die Phasensteuerungseinheit 8 den Pulsgenerator 12 des Strahlaustastsystems 1. Das Signal der ausgelösten Sekundärelektronen 6 erscheint infolge Laufzeit der Primärelektronen 4 mit einer Verzögerung am Eingang der Torschaltung 10. Zur gleichen Zeit, wenn das Signal der ausgelösten Sekundärelektronen 6 am Eingang der Torschaltung 10 erscheint, wird die Torschaltung über die eingebaute Verzögerungsschaltung 11 so angesteuert, dass das Signal der Sekundärelektronen 6 verstärkt wird. Der Boxcar Integrator liefert ein Signal 15, das der Signalhöhe der Sekundärelektronen 6 proportional ist. Die gesamte Anordnung weist noch ein elektronisches Zusatzgerät 13 zur Ansteuerung des Messobjekts 5 und zur Ansteuerung der Phasensteuerungseinheit 8 auf.

Figur 2 zeigt die Beschaltung eines Strahlaustastsystems 1 nach der oben angegebenen Methode I. Die Ablenkstruktur 2 wird geerdet, während an die Ablenkstruktur 3 eine Gleichspannung angelegt wird. Ein dieser Gleichspannung überlagerter Austastimpuls legt diese Ablenkstruktur 3 auf Erdpotential. Während des Austastimpulses ist der Raum zwischen den Ablenkstrukturen 2, 3 feldfrei, so dass der Primärelektronenstrahl 4 eingeschaltet ist. Die Elektronen-Pulsbreite wird bei diesem Verfahren durch die Breite des angelegten Austastimpulses bestimmt. Die kleinste bisher damit erreichte Pulsbreite beträgt 350 ps.

Figur 3 zeigt die Beschaltung eines Strahlaustastsystems 1 nach der oben angegebenen Methode II. Die Ablenkstruktur 2 ist wiederum geerdet, während an der Ablenkstruktur 3 eine negative Gleichspannung $-U_0$ angelegt wird. Ein dieser Gleichspannung überlagerter Austastimpuls legt diese Ablenkstruktur 3 auf das Potential $+U_0$. Während jeder Flanke eines Austastimpulses wird der Elektronenstrahl 4 über eine nicht dargestellte Blende hinweg abgelenkt. Entsprechend der Anstiegs- und Abfallflanke eines jeden Austastimpulses liefert diese Beschaltung zwei Primärelektronenpulse 4 pro Austastimpuls. Mit dieser Beschaltung können kürzere Pulsbreiten erreicht werden ($\approx 10$ ps).

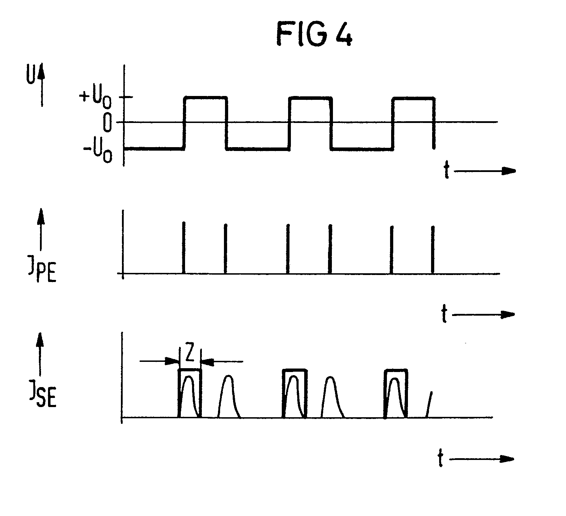

Figur 4 zeigt das Prinzip der stroboskopischen Potentialmessung mit einer erfindungsgemässen Anordnung. Erfindungsgemäss werden die Ablenkstrukturen 2, 3 nach der Methode II (Figur 3) beschaltet, so dass pro Periode des hochfrequenten periodischen Vorgangs im Messobjekt 5 zwei Elektronenpulse 4 erzeugt werden. Bei der Signalverarbeitung wird ein zeitliches Fenster Z so gesetzt, dass pro Periode des hochfrequenten periodischen Vorgangs im Messobjekt 5 nur das Signal eines einzigen Sekundärelektronenpulses gemessen wird. Figur 4 zeigt die an die Ablenkstruktur angelegte Spannung U, den damit erzeugten gepulsten Primärelektronenstrom $I_{PE}$ und den mittels der Spannung U am Strahlaustastsystem 1 erzeugten gepulsten Strahlstrom $I_{PE}$ der Primärelektronen-4 und den dadurch verursachten gepulsten Strahlstrom $I_{SE}$ der Sekundärelektronen 6, dessen Signal infolge Laufzeit der Primärelektronen 4 mit einer Verzögerung an der Torschaltung 10 erscheint.

Die erfindungsgemässe Anordnung hat gegenüber den bekannten Anordnungen den Vorteil, dass zwischen den Betriebsarten nach der Methode I und nach der Methode II auf einfache Art umgeschaltet werden kann. Als Boxcar-Integrator 14 wurde das Gerät Model 162 der Fa. PAR verwendet.

Die erfindungsgemässe Anordnung kann auch noch mit symmetrisch geschalteten Ablenkstrukturen 2, 3 betrieben werden, wie dies von H.-P. Feuerbaum und J. Otto in der angegebenen Veröffentlichung beschrieben ist. Die eine Ablenkstruktur liegt dann bei Sperrbetrieb auf dem Potential $+U_0$, während die andere Ablenkstruktur auf dem Potential $-U_0$ liegt. Der Primär-Elektronenstrahl 4 wird dadurch eingeschaltet, dass die Ablenkstrukturen 2,3 vom Austastimpuls auf das Null-Potential gelegt werden.

**Patentansprüche**

1. Anordnung für stroboskopische Potentialmessungen mit einem gepulsten Elektronenstrahl, die ein Strahlaustastsystem mit einem Pulsgenerator aufweist, bei dem der Primär-Elektronenstrahl während jeder Flanke eines Austastimpulses über eine Blende hinweg abgelenkt wird, wobei pro Austastimpuls zwei Primär-Elektronenpulse erzeugt werden, sowie eine Einrichtung zum Nachweis von Sekundärelektronen und zum Verarbeiten von Sekundär-Elektronensignalen, gekennzeichnet durch einen «Boxcar-Integrator» (9) zum Verarbeiten von jeweils einem der zwei pro Austastimpuls erzeugten Sekundär-Elektronensignale, dem eine Torschaltung (10) vorgeschaltet ist, sowie durch eine Phasensteuerungseinheit (8), die über eine Verzögerungsschaltung (11) mit der Torschaltung (10) und direkt mit dem Pulsgenerator (12) des Strahlaustastsystems (1) verbunden ist.

2. Verfahren zum Betrieb einer Anordnung nach Anspruch 1, dadurch gekennzeichnet, dass die Anordnung zeitweise auch so geschaltet wird, dass während der Dauer des gesamten Austastimpulses der Elektronenstrahl die Blende des Austastsystems passiert.

**Claims**

1. An arrangement for stroboscopic potential measurements comprising a pulsed electron beam having a beam blanking system with a pulse generator, wherein during each flank of a blanking pulse the primary electron beam is deflected across a diaphragm, producing two primary electron pulses for each blanking pulse, and a device for the identification and processing of secondary electron signals, characterised by a "Boxcar Integrator" (9) for respectively processing one of the two secondary electron signals produced for each blanking pulse, which boxcar integrator is preceded by a gate circuit (10), and characterised by a phase control unit (8) connected via a delay circuit (11) to the gate circuit (10) and directly connected to the pulse generator (12) of the beam blanking system (1).

2. A method for the operation of an arrangement as claimed in Claim 1, characterised in that the arrangement is temporarily switched in such manner that the electron beam passes the diaphragm of the blanking system during the duration of the entire blanking pulse.

**Revendications**

1. Dispositif pour effectuer des mesures stroboscopiques de potentiel à l'aide d'un faisceau électronique pulsé, ce dispositif comportant un système de suppression du faisceau comportant un générateur d'impulsions et dans lequel le faisceau d'électrons primaires est dévié, au niveau de chaque flanc d'une impulsion de suppression, en direction d'un diaphragme, avec production de deux impulsions d'électrons primaires pour chaque impulsion de suppression, ainsi qu'un dispositif pour détecter des électrons secondaires et pour traiter des signaux d'électrons secondaires, caractérisé par un «intégrateur Boxcar» (9) servant à traiter respectivement l'un des deux signaux électroniques produits lors de chaque impulsion de suppression et en amont duquel est branché un circuit de porte (10), ainsi qu'une unité (8) de commande de phase, qui est reliée par l'intermédiaire d'une ligne à retard (11) au circuit de porte (10) et directement au générateur d'impulsions (12) du système (1) de suppression du faisceau.

2. Procédé d'exploitation d'un dispositif suivant la figure 1, caractérisé par le fait que le dispositif est également alimenté de temps en temps de telle sorte que pendant la durée de l'impulsion totale de suppression, le faisceau électronique traverse le diaphragme du système de suppression.

**FIG 1**

**FIG 2**

**FIG 3**

# FIG 4